# EUROPEAN PATENT APPLICATION

(11) **EP 3 614 399 A1**
(43) Date of publication of application: **26.02.2020**
(21) Application number: 18190412.9
(22) Date of filing: 23.08.2018
(51) Int. Cl.: H01B 1/02, H01B 1/22

(54) **A METHOD FOR MANUFACTURING MODIFIED ELECTRICALLY-CONDUCTIVE COPPER PARTICLES AND MODIFIED ELECTRICALLY-CONDUCTIVE COPPER PARTICLES MANUFACTURED THEREOF**

(71) Applicant: Centrum Badan i Rozwoju Technologii dla Przemyslu S.A., 00-120 Warszawa (PL)
(72) Inventor: Socha, Robert, 32-091 Michalowice (PL); Panek, Piotr, 34-120 Andrychow (PL); Putynkowski, Grzegorz, 00-193 Warszawa (PL); Mordarski, Grzegorz, 30-047 Krakow (PL); Balawender, Pawel, 31-223 Krakow (PL); Musztyfaga-Staszuk, Malgorzata, 44-194 Knurow (PL)
(74) Representative: Kancelaria Eupatent.pl Sp. z.o.o

(57) **Abstract**

A method for manufacturing modified electrically-conductive copper particles, the method comprising the step of: introducing copper particles into a water bath comprising: at least one water-soluble metal salt comprising at least one metal cation selected from the metal cation group comprising nickel cation on the oxidation degree of +2 (Ni²⁺), wherein the metal cations concentration in the water bath is from 5.10⁻² to 200.10⁻² mol/dm³, at least one phosphoric reducing agent comprising phosphorus on the oxidation degree from +1 to +3, wherein the molar ratio of the metal cations to the phosphoric reducing agent in the water bath is from 0,1 to 2, at least one buffer agent for stabilizing pH of the water bath in the range of 4 to 7, and at last one surfactant, and the step of heating the water bath with the copper particles to a temperature from 30 to 99°C, to obtain modified electrically-conductive copper particles.

## Description

### TECHNICAL FIELD

The present disclosure relates to a modified electrically-conductive copper particles with a barrier coating and a method for manufacturing thereof.

The electrically conductive copper particles according to the present disclosure assure satisfactory electrical conductivity and, therefore, the modified copper particles can be used as a component of electrically-conductive compositions, such as pastes, inks, paints, composites, in particular for forming electrically-conductive paths and electrodes, especially in silicon-based solar cells.

### BACKGROUND

There are known electrically-conductive compositions, such as pastes, inks or paints, suitable for printing electro-conductive paths, electrodes, contacts or heaters, in a form of layers, films or grids, comprise conductors which are, i.a. metals or metal alloys.

In silicon-based solar cells, the electrically-conductive printing compositions are used for forming upper and lower electrodes, at least partially overlapping semi-conductive silicon-based substrate. In order to achieve desired solar cell performance, the conductors forming solar cell electrodes are expected to show not only high conductivity and low resistance, but also compatibility with other components of electrically-conductive composition and substrate, good migration resistance, proper melting point, adequate thermal conductivity, proper coefficient of linear thermal expansion, etc. There are known some metal elements which show the expected properties and which can be used, as conductors, in electrically-conductive printing compositions.

One of the most popular conductors that meets the above mentioned strict criteria, is silver (Ag). There are known silver pastes for screen-printing of electrodes in silicon-based solar cells. The known pastes typically consist of silver powder in amount of about 70-90% by weight, glass frit powder comprising bismuth oxide (Bi₂O₃) or silicon oxide (SiO₂) in the amount not exceeding 30% by weight, and an organic solvent system typically based on ethyl cellulose and terpineol in the amount of about 2 - 12% by weight. The paste achieves its electrically-conductive properties after suitable heat treatment, typically involving sintering or calcination at high temperatures.

The silver component in the electroconductive paste is a conductor - providing electrical paths, whereas the remaining paste ingredients create a connection between the electrode formed from the paste and semi-conductive silicon substrate, the quality of which influences the mechanical and electrical Ag-Si contact.

Nonetheless, silver is an expensive element and therefore it increases the material costs of solar cells production. Accordingly, there are known electrically-conductive compositions for use in solar cells, and in particular in silicon-based solar cells, wherein the silver conductor is partially or completely replaced with other metals or metal alloys to provide lower material costs.

From the patent literature, there are known electrically-conductive compositions in which silver powder is partially or completely replaced with modified copper grains.

A Chinese patent publication CN103700428 discloses an electrically-conductive paste for silicon solar cell electrodes. The paste comprises 50 - 90% by weight of mixed spherical copper powder and scaly copper powder of average particle size of 0,5 to 5 µm. The copper powder constitutes a low-cost replacement of silver. The surface of the copper grains is coated with a nickel plating layer and optionally a tin plating layer. Nonetheless, CN103700428 fails to describe the method for coating of the copper grains with nickel or tin layer.

A Chinese patent publication CN105225723 describes an electrically conductive paste for production of electrodes in Si-based solar cells. The paste comprises copper phosphide powder, in the amount of 70 to 90% by weight - as the conductive element. The used copper grains have a surface coating in the form of a phosphor bronze alloy film on the copper surface. Such coating provides a good conductivity of the electrode formed after sintering of the paste.

A Chinese patent publication CN106128547 discloses an electroconductive paste comprising 4 to 8 parts by weight of copper nanoparticles, in a powder form.

A PCT patent application WO2012135551 describes an electrically-conductive paste for screen printing to produce printed circuits, conductive lines and conductive surfaces in the form of thin films, for the application in Si-based solar cells. The paste comprises silver and it can comprise other conductors, such as copper, in the total amount of about 50 to 95% by weight.

A European patent application EP2500910 discloses an electro-conductive copper nano-paste composition. The paste comprises copper nanoparticles in the amount of 1 to 95 parts by weight, wherein the copper particles have a particle size of 150 nm or less and the copper particles are coated with capping material consisting of fatty acids and fatty amines.

A European patent application EP2782102 discloses an electro-conductive past composition for production electrodes in solar cells. The paste composition comprises a phosphorus-containing copper alloy particle, a tin-containing particle, a nickel-containing particle as electrically-conductive agents.

As follows from the above-mentioned patent publications, the form of copper particles, intended to partially or completely replace silver particles in electrically-conductive compositions for production of electrically-conductive paths on silicone-based substrates, such as electrodes in Si-based solar cells, undergoes constant development in order to provide better electro-conductivity of the electrical paths as well as enhanced performance of the silicon-based solar cells.

Therefore, there is a need to further develop and modify conductors based on copper to be useful for various electrically-conductive compositions, such as pastes, inks or paints, in particular dedicated to silicon-based substrates, such as silicon-based solar cells, in order to improve the electro-conductive parameters of the cells.

### SUMMARY

There is presented a method for manufacturing modified electrically-conductive copper particles, the method comprising the step of: introducing copper particles into a water bath comprising: at least one water-soluble metal salt comprising at least one metal cation selected from the metal cation group comprising nickel cation on the oxidation degree of +2 (Ni²⁺), wherein the metal cations concentration in the water bath is from 5·10⁻² to 200·10⁻² mol/dm³, at least one phosphoric reducing agent comprising phosphorus on the oxidation degree from +1 to +3, wherein the molar ratio of the metal cations to the phosphoric reducing agent in the water bath is from 0,1 to 2, at least one buffer agent for stabilizing pH of the water bath in the range of 4 to 7, and at last one surfactant, and the step of heating the water bath with the copper particles to a temperature from 30 to 99°C.

Preferably, the metal cation group further comprises silver cation having the oxidation degree of +1 (Ag⁺).

Preferably, the metal salt is selected from the group consisting of sulfate (IV), sulfate (VI), nitrate (III), nitrate (V), acetate, chloride and bromide.

Preferably, the phosphoric reducing agent is selected from the group consisting of phosphoric acid (I) (H₃PO₂), phosphoric acid (III) (H₂PO₃) and phosphorus oxide (III) (P₄O₆).

Preferably, the buffer agent is selected from the group consisting of succinic acid and sodium succinate buffer solution, phosphoric acid and sodium or potassium phosphate buffer solution and boric acid and sodium borate buffer solution.

Preferably, the surfactant is selected from the group consisting of dodecyl sodium sulfate (CAS no. 151-21-3), 2-bromo-3-methoxyphenol (CAS no. 68439-57-6), 5-chloro-2-methyl-3(2H)-isothiazolone with 2-methyl-3(2H)-isothiazolone (CAS no. 55965-84-9) and sodium laureth sulfate (CAS no. 68891-38-3).

Preferably, the water bath with the copper particles is heated to the temperature from 80 to 95 °C.

There are also presented electrically-conductive copper particles prepared by the above-presented method.

Preferably, the copper particles have an average diameter in the range from 0,5 to 20 µm.

Preferably, the modified copper particles comprise a coating comprising nickel and phosphorus.

Preferably, the modified copper particles comprise a coating comprising nickel, silver and phosphorus.

Preferably, the coating has a thickness of 1 to 1000 nm.

There is further presented an electrically-conductive composition comprising the modified electrically-conductive copper particles.

There is also presented a silicon-based solar cell comprising electrically-conductive paths and/or electrodes made of the electrically-conductive composition.

### BRIEF DESCRIPTION OF FIGURES

The present disclosure is presented by means of exemplary embodiments in a drawing in which:
Fig. 1 is a schematic representation of the chemical reaction leading to the formation of a coating on the copper particles,
Figs. 2A, 2B show SEM pictures of different copper particles to be used for the preparation of modified electrically-conductive cooper particles according to the present disclosure,
Fig. 3 shows an analysis of contamination of copper particles surface to be used for the preparation of modified electrically-conductive cooper particles according to the present disclosure,
Fig. 4 shows a table of a conductive characteristic of silicon-based solar cells having the upper electrodes made of a paste comprising modified electrically-conductive copper particles according to the present disclosure.

### DETAILED DESCRIPTION

According to the present disclosure, the electrically-conductive copper (Cu) particles are provided with a coating comprising: nickel (Ni) and phosphorus: Cu/Ni-P and optionally silver: Cu/Ni-P-Ag. Such coating of the electrically-conductive copper particles, and especially the developed coating composition, provides a significant reduction of the diffusion of copper atoms, from copper particles, into the silicon substrate. The aforementioned effect is especially relevant in the case of thermal treatment of the electrically conductive composition applied on the silicon substrate in order to create electrical paths, wherein the treatment is conducted at the temperatures of up to 950°C, involving for example sintering or calcination. Moreover, the reduced effect of copper diffusion from the electrode into the silicon substrate is also relevant during operation of solar cells comprising such the electrode.

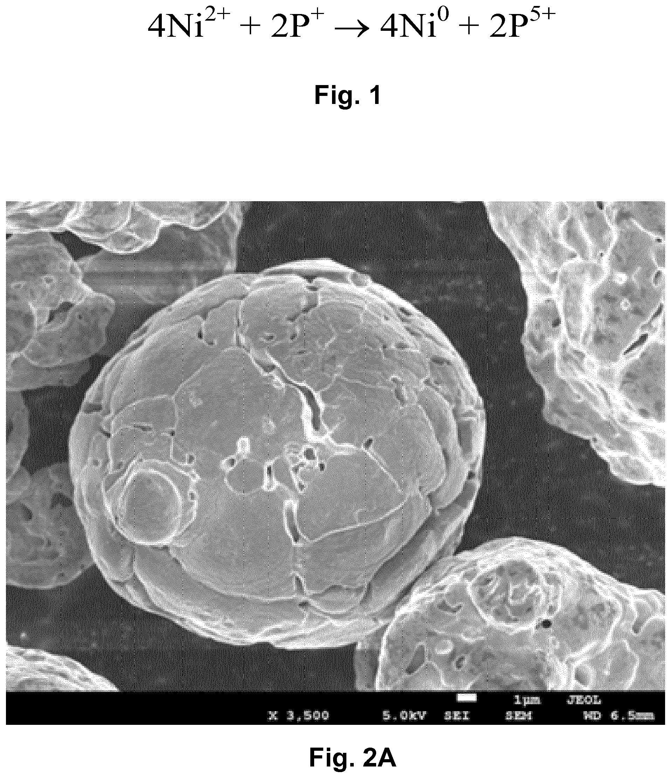

The method for manufacturing the electrically-conductive copper with a coating comprising nickel and phosphorus and optionally silver involves an electroless process. The formation of the coating on the surface of copper particles involves the chemical redox reaction conducted in the presence of phosphorus, oxygen, hydrogen and metal cations to be reduced, i.e.: nickel and optionally silver. As shown in Fig. 1, the product of the redox reaction is a coating comprising uncombined nickel - in a free state (Ni⁰) and bonded phosphorus, and optionally uncombined silver - in a free state (Ag⁰).

Preferably, the obtained coating comprises nickel to phosphorus atomic ratio (Ni:P) that equals from 1 to 6. Such ratio of nickel and phosphorus provides an efficient barrier for copper diffusion. More preferably, the coating comprises nickel to phosphorus atomic ratio (Ni:P) that equals 2.2 which provides the effect of better barrier for copper diffusion, and thus reduced copper diffusion. Furthermore, the obtained coating may comprise nickel and phosphorus to silver atomic ratio (Ni+P:Ag) that equals from 900 to 1. Such ratio provides the effect of sufficient conductivity of the modified copper particles. More preferably, the coating may comprise nickel and phosphorus to silver atomic ratio (Ni+P:Ag) that equals 70, which provides the effect of better conductivity of the modified copper particles. The atomic ratio can be determined from the analysis of X-ray photoelectron spectra (XPS) or form the analysis of X-ray fluorescence spectra (XRF).

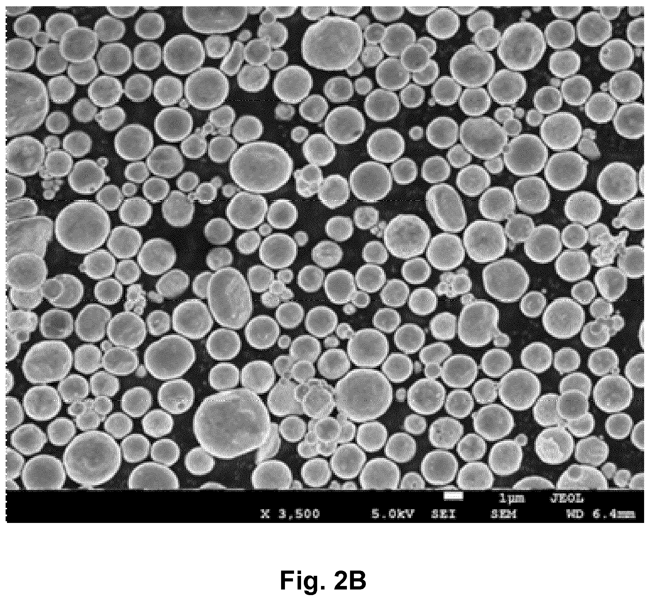

According to the method of the present disclosure, the coating may be formed on the surface of copper particles having the average diameter of 0.5 to 20 µm. The average diameter can be measured by means of a high-resolution scanning electron microscope (SEM) on at least 20 grains, whereas the average diameter is calculated as an arithmetic average. Moreover, the method is suitable for coating copper particles of various surface morphology and various shapes. Figs. 2A and 2B show SEM images of exemplary copper particles (magnitude: x3500) that can be coated according to the present disclosure. The copper particles to be coated may be of a spherical or ellipsoidal shape as well as the shape of wires, flakes, grains, lumps, as well as other non-geometrical shapes.

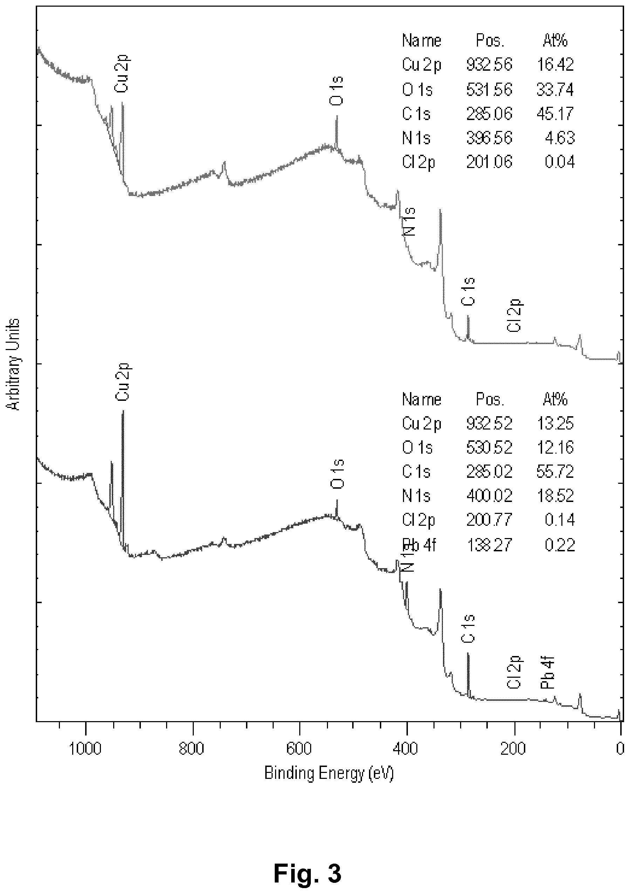

Furthermore, the method may be used for coating even in case the copper particles surface includes impurities. Fig. 3 shows the exemplary concentration of impurities on the surface of copper particles, which may be coated according to the presented method. The surface of copper particles may be for example contaminated with oxide, coal, nitrogen, chlorine or lead. The method is also suitable for copper particles of various surface wettability: hydrophilic and hydrophobic copper particles may be coated as well.

The impurities as well as different surface wettability do not affect the properties of the coated electrically-conductive copper particles obtained according the presented method.

The method for manufacturing electrically-conductive copper with nickel, phosphorous coating consists in the introduction of Cu particles into the water bath that comprises:
- at least one water-soluble nickel salt comprising nickel cation: Ni²⁺, and optionally at least one water-soluble silver salt comprising silver cation: Ag⁺, preferably the salt is selected from the group consisting of: sulfate (IV), sulfate (VI), nitrate (III), nitrate (V), acetate, chloride, and bromide. The total concentration of metals cations: nickel and optionally silver in the water bath is of 5·10⁻² to 200·10⁻² mol/dm³. Preferred salts which can be used for bath preparation are NiSO₄ and optionally AgNO₃,
- at least one surfactant selected from the group of cationic, anionic and nonionic surfactants. Preferably, the surfactant may be selected from the group consisting of dodecyl sodium sulfate (CAS no. 151-21-3), 2-bromo-3-methoxyphenol (CAS no. 68439-57-6), 5-chloro-2-methyl-3(2H)-isothiazolone with 2-methyl-3(2H)-isothiazolone (CAS no. 55965-84-9) and sodium laureth sulfate (CAS no. 68891-38-3). Nonetheless, another surfactant of similar activity may be also used. Prepferably, the total surfactant concentration in the water bath is of 1·10^{-7 to} 1000·10⁻⁷ mol/dm³,
- at least one phosphoric reducing agent that comprises phosphorus on the oxidation degree of +1 to +3. The phosphoric reducing agent may be selected from various compounds such as for example phosphoric acid (I) (H₃PO₂) and/or salts of this acid, for example, hydrogen phosphates, phosphoric acid (III) (H₂PO₃) and/or salts of this acid. Moreover, the phosphoric reducing agent may be selected from phosphoric oxides such as for example phosphorus oxide (III) (P₄O₆). The total concentration of phosphoric reducing agent should be selected so as to obtain the molar ratio of total metal cations sum: Ni²⁺ and Ag⁺- if present, to phosphoric reducing agent (Ni²⁺ + Ag⁺ : phosphoric reducing agent) of 0,1 to 2, and
- at least one buffer agent for stabilizing pH of the water bath in the range of 4 to 7. For example, the buffer may be selected from the group consisting of: succinic acid and sodium succinate buffer solution, phosphoric acid and sodium or potassium phosphate buffer solution, boric acid and sodium borate buffer solution as well as other buffer solutions that can maintain pH level in the range of 4 to 7.

The copper particles may be introduced into the water bath in various forms, preferably in a form of a powder or a suspension. Preferably, 5-200 g of Cu particles are introduced per 1 liter of the water bath.

The water bath with the copper particles is mixed and heated to the temperature in the range of 30 to 99 °C, and preferably to the temperature in the range of 80 to 95 °C.

The coating process occurs in the water bath of the aforementioned composition due to the ongoing redox reaction leading to the reaction product: modified electrically-conductive copper particles.

The coating process, depending on the needs, may be repeated, at least once, and preferably twice, or three times, or four times or more. Repeating of the coating process enables to obtain the coating of required, controlled thickness. According to the presented method, one may obtain the coating thickness in the range of 1 to 1000 nm (measured from TEM cross-section of the coated copper grain). The thickness of the obtained nickel/phosphorus coating or nickel/phosphorus/silver coating on the copper particles depends on the ratio of BET specific surface of Cu particles (which can be measured by the use of BET isotherm technique based on nitrogen adsorption) present in the water bath and the total mass of metal ions, namely nickel (Ni²⁺) and silver (Ag⁺) - if present in the water bath. Whereas, the higher is the metal ion mass, the thicker is the coating formed on the copper particles surface.

The coating process, according to the present disclosure may be conducted in a batch or a continuous mode, depending on the needs. The continuous process may be carried out in a flow reactor, whereas the batch process may be carried out in a batch reactor.

After the coating process is completed, the coated copper particles are separated from the water bath, washed with water and dried in the air in a temperature not exceeding 200°C.

The copper particles, coated with nickel, phosphorus and optionally silver, constitute a low-cost replacement of a silver powder, and may be used in electrically-conductive compositions, such as pastes, inks or paints, especially for preparation of electrodes in silicon-based solar cells, in which the coated copper particles show enhanced properties due to the developed coating composition which sufficiently reduces the diffusion of copper atoms from the copper particles into the silicon-based substrate. Preferably, the electrically-conductive composition may comprise the modified electrically-conducive copper in the range of 3 to 90% by weight.

The copper particles modified according to the method of the present disclosure may be therefore used for preparation of electrically-conductive printing pastes, where the modified copper acting as a conductive paste ingredient may replace silver in whole or in part. The same applies to other electrically-conductive compositions, such as inks or paints. The preparation of the electrically-conductive composition comprising the modified copper particles may involve for example known preparation techniques, in which the modified copper is introduced in the same way as a typical conductive ingredient. Moreover, the modified copper may be used, as an additive, in commercially available electrically conductive compositions, into which the modified copper may be introduced for example in the form of powder or suspension. Such the addition provides enhancement of certain properties of electrically-conductive composition as well as reduction of silver content in the composition.

Furthermore, the modified copper particles may be used in various electrically-conductive compositions suitable, among others, for screen printing, ink-jet printing, drop on demand printing, tampon printing, typographic printing as well as other printing techniques. Preferably, such the electrically-conductive composition comprises the modified electrically-conducive copper in the range of 3 to 90% by weight.

Moreover, the modified copper according to the present method may be used for the preparation of components for other than the electrodes purposes, such as for example heating elements, heaters, electrically-conductive paths, circuits and contacts covering.

### EXAMPLE 1 - preparation of modified electrically-conductive copper particles:

### A) preparation of electrically-conductive copper particles: Cu/Ni-P:

30 g of copper powder of copper particles having average diameter of 5 µm was introduced into 1 liter of the water bath comprising: 28 g NiSO₄·7H₂O, 21 g NaH₂PO₂·H₂O, 54 g Na₂C₄H₄O₄·H₂O, 24 g C₄H₆O₄. Next, the bath was heated to the temperature of 95 °C. After the formation of Ni-P coating on the Cu particles surface, the modified electrically-conducive copper particles were removed from the bath, rinsed with water and dried in the air atmosphere.

### B) preparation of electrically-conductive copper particles: Cu/Ni-P-Ag:

There was prepared the water bath comprising 28 g NiSO₄·7H₂O, 21 g NaH₂PO₂·H₂O, 54 g Na₂C₄H₄O₄·6H₂O, 24 g C₄H₆O₄. Into the bath there were introduced: 10 g of AgNO₃ and 30 g of copper powder of copper particles having an average diameter of 5 µm. Next, the bath was heated to the temperature of 95 °C. After the formation of the Ni-P-Ag coating on the Cu particles surface, the modified electrically-conducive copper particles were removed from the bath, rinsed with water and dried in the air atmosphere.

### EXAMPLE 2 - Preparation of solar cells

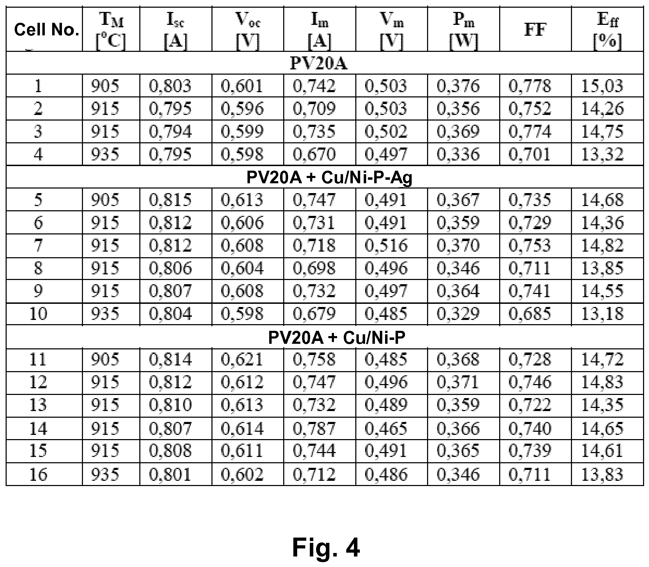

A series of silicon-based plates were prepared for manufacturing solar cells, each having a surface area of 5 x 5 cm. The plates were prepared on the basis of silicon: Cz-Si p-type (i.e. the monocrystalline silicon obtained by the Czochralski's method). Plates parameters: resistivity: 1 Ωm, thickness: 170 µm with the surface of crystallographic orientation: (100). After cleaning the surface of the plates in the chemical baths, on the plates surface there was prepared an emitter of sheet resistivity Rₛₕₑₑ of 50 Ω/square, by means of the donor doping process - from the source of POCl₃ in the atmosphere of N₂ and O₂, within 30 minutes, at the temperature of 845 °C. After removal of the enamel silicon-phosphoric layer (PSG) in the mixture of HF: H₂O (1: 9 v/v), on the plates, after the oxidation with dried O₂, a layer of SiO₂ was formed, within 10 minutes, at the temperature of 830 °C. On the SiO₂ layer, by means of chemical vapor deposition from (C₂H₅O)₄Ti, an antireflective layer of TiO₂ of the thickness 80 nm was applied. On the face side of the solar cells, a collecting electrode was formed from the electrically-conductive paste. The paste was prepared by introducing, into a commercially available paste: PV20A, DuPont (France), the modified copper particles: Cu/Ni-P-Ag in the amount of 100 g per 100 g of paste PV20A, and/or the modified copper particles: Cu/Ni-P in the amount of 100 g per 100 g of paste PV20A (prepared according to Example 1 a and b above). On the back side of plates, there were formed contacts made from the commercially available paste PV505 Du Pont (France) and a covering surface rear electrode made from paste PV381 Du Pont (France) based of Al powder. After drying at the temperature of 200 °C within 15 minutes, the formed structures were subjected to heat treatment in an infrared (IR) belt oven with the linear speed of 200cm/minute at the purified natural atmosphere, at the temperature range of 905 - 935 °C. The prepared solar cells were measured at the testing station of Solar Light Simulator SS200 of class AAA of EM Photo Emission Tech., Inc. (USA) at the conditions of STC for spectrum: AM1.5G, at the lighting intensity of 1000 W/m² and temperature of 25 °C. The measurement of the bright current-voltage characteristics (I-V) of the cells was conducted using the Solar Cells I-V Curve Tracer SS I-V CT-02 PV system. Calibration of the station was performed using the reference cell No. 005-2013 from the Fraunhofer Institute of Solar Energy (Germany). The obtained test results are presented in the table in Fig. 4, where the abbreviations used indicate: T_{M} - metallization temperature, I_{sc} - short-circuit current, V_{oc} - open-circuit voltage, Iₘ - current at the maximum power point, Vₘ - voltage at the maximum power point, Pₘ - power at the maximum power point, FF - fill factor, E_{ff} - photovoltaic efficiency.

As follows from the table of Fig. 4, the prepared silicon-based solar cells, comprising the electrode formed from the electrically-conductive paste comprising copper particles modified according to the present invention, show parameters which correspond with the parameters of solar cells having electrodes comprising silver - as the electrically-conductive ingredient. The parameter, which indicates the correct barrier for the diffusion of copper atoms into the p-n connection zone, is the fill factor (FF) which, for the cells prepared form the paste comprising modified copper particles according to the present disclosure, equals 0,74 and 0,75, respectively.

## Claims

1. A method for manufacturing modified electrically-conductive copper particles, the method comprising the steps of:
- introducing copper particles into a water bath comprising:
- at least one water-soluble metal salt comprising at least one metal cation selected from the metal cation group comprising nickel cation on the oxidation degree of +2 (Ni²⁺), wherein the metal cations concentration in the water bath is from 5·10⁻² to 200·10⁻² mol/dm³,
- at least one phosphoric reducing agent comprising phosphorus on the oxidation degree from +1 to +3, wherein the molar ratio of the metal cations to the phosphoric reducing agent in the water bath is from 0,1 to 2,
- at least one buffer agent for stabilizing pH of the water bath in the range of 4 to 7, and
- at last one surfactant;
- and heating the water bath with the copper particles to a temperature from 30 to 99°C.

2. The method according to claim 1, wherein the metal cation group further comprises silver cation having the oxidation degree of +1 (Ag⁺).

3. The method according to claim 1 or 2, wherein the metal salt is selected from the group consisting of sulfate (IV), sulfate (VI), nitrate (III), nitrate (V), acetate, chloride and bromide.

4. The method according to any of the preceding claims, wherein the phosphoric reducing agent is selected from the group consisting of phosphoric acid (I) (H₃PO₂), phosphoric acid (III) (H₂PO₃) and phosphorus oxide (III) (P₄O₆).

5. The method according to any of the preceding claims, wherein the buffer agent is selected from the group consisting of succinic acid and sodium succinate buffer solution, phosphoric acid and sodium or potassium phosphate buffer solution and boric acid and sodium borate buffer solution.

6. The method according to any of the preceding claims, wherein the surfactant is selected from the group consisting of dodecyl sodium sulfate (CAS no. 151-21-3), 2-bromo-3-methoxyphenol (CAS no. 68439-57-6), 5-chloro-2-methyl-3(2H)-isothiazolone with 2-methyl-3(2H)-isothiazolone (CAS no. 55965-84-9) and sodium laureth sulfate (CAS no. 68891-38-3).

7. The method according to any of the preceding claims, wherein the water bath with the copper particles is heated to the temperature from 80 to 95 °C.

8. Modified electrically-conductive copper particles prepared by the method according to any of claims from 1 to 7.

9. The modified electrically-conductive copper particles prepared by the method according to any of claims from 2 to 7.

10. The modified electrically-conductive copper particles according to claim 8 or 9, wherein the copper particles have an average diameter in the range from 0,5 to 20 µm.

11. The modified electrically-conductive copper particles according to claim 8 wherein the modified copper particles comprise a coating comprising nickel and phosphorus.

12. The modified electrically-conductive copper particles according to claim 9 wherein the modified copper particles comprise a coating comprising nickel, silver and phosphorus.

13. The modified electrically-conductive copper particles according to any of claims 11 and 12 wherein the coating has a thickness of 1 to 1000 nm.

14. An electrically-conductive composition comprising the modified electrically-conductive copper particles according to any of claims 8-13.

15. A silicon-based solar cell comprising electrically-conductive paths and/or electrodes made of the electrically-conductive composition of claim 14.
